# EUROPEAN PATENT APPLICATION

(11) **EP 4 715 873 A1**
(43) Date of publication of application: **25.03.2026**
(21) Application number: 25174573.3
(22) Date of filing: 06.05.2025
(51) Int. Cl.: H01L 23/31, H01L 23/58, H10D 62/10, H10D 30/66, H10D 62/832

(54) **SEMICONDUCTOR STRUCTURE AND MANUFACTURING METHOD THEREOF**

(30) Priority: 23.09.2024 TW 113136048
(71) Applicant: ProAsia Semiconductor Corporation, Hsinchu 30078 (TW)
(72) Inventor: SU, Hsin-Ming, 30078 Hsinchu (TW); TSAI, Ming-Yan, 30078 Hsinchu (TW)
(74) Representative: Michalski Hüttermann & Partner Patentanwälte mbB

(57) **Abstract**

A semiconductor structure and a manufacturing method thereof are provided. The semiconductor structure comprises a cell region, a junction terminal region, a street line and a passivation layer. The junction terminal region is disposed to surround the cell region and has a plurality of guard rings which are disposed in the junction terminal region and surround the cell region. The street line is disposed to surround the junction terminal region. The passivation layer covers the junction terminal region and the street line, and the passivation layer substantially prevents the street line from being damaged due to arcing generated during a high-voltage test.

## Description

### CROSS-REFERENCES TO RELATED APPLICATIONS

This application claims the benefit of priority to Taiwanese Patent Application No. 113136048 filed on September 23, 2024, which is hereby incorporated by reference in its entirety.

### BACKGROUND OF THE INVENTION

### Field of the Invention

The present invention relates to a semiconductor structure, in particular, to a power semiconductor device.

### Descriptions of the Related Art

Silicon carbide (SiC) power semiconductor devices are high-performance power devices fabricated using materials of silicon carbide. Compared to conventional silicon (Si) semiconductors, SiC power semiconductor devices offer higher breakdown voltages, thermal conductivity, and electron saturation velocity for providing significant performance advantages in high-power, high-temperature, and high-frequency applications.

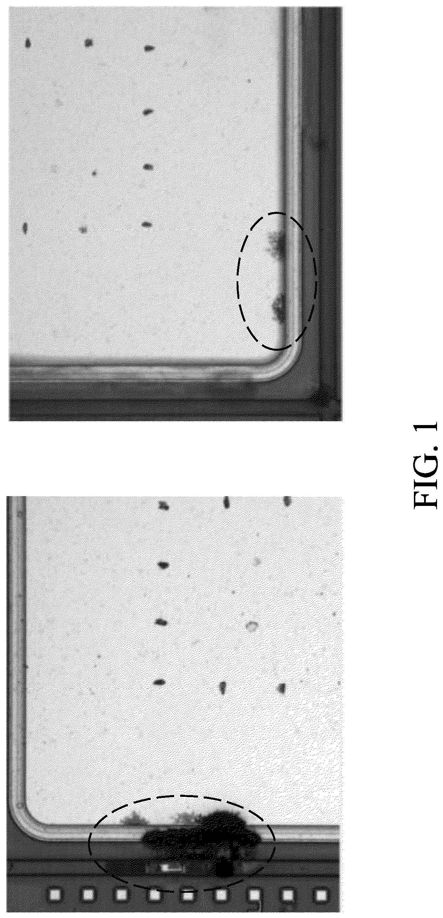

During the manufacturing of SiC power semiconductor devices, chip probing (CP) tests are typically performed especially at high voltages (e.g., 1200V, 1700V, or 3300V). However, current SiC semiconductor structures often experience arcing at the wafer edges during CP testing. This arcing can interfere with test results and even damage the devices. For example, the damaged areas at the wafer edges are indicated by dashed regions in FIG. 1.

Arcing occurs due to the strong electric field under high voltage and causes electrical breakdown and instantaneous discharge in the air or medium. To prevent this arcing phenomenon, traditional manufacturing processes adopt several countermeasures during CP testing. First, isolation oil is applied to cover the testing area on the probe station to enhance dielectric strength and reduce electric field concentration for effectively preventing arcing in the air. However, special cares must be taken to clean the equipment afterward to avoid contamination of the test equipment or wafer surface. Second, a sealed test environment is created inside the probe station, and an inert gas of nitrogen is introduced to reduce the possibility of arcing. However, this approach requires additional hardware to create a sealed space. It is unsuitable for all testing setups. Third, a probe card equipped with airflow ducts is used to introduce clean dry air (CDA). The dry, clean air maintains low humidity around the probe card and testing environment for preventing arcing caused by moisture or contaminants. However, compared to the first two measures, CDA probe cards are less effective at suppressing arcing under extremely high voltages. Thus, reducing arcing during CP testing of power semiconductor devices remains an urgent challenge in the industry.

### SUMMARY OF THE INVENTION

The main objective of the present invention is to provide an innovative semiconductor structure and its manufacturing method to avoid device damage caused by arcing in the edge area of the structure during high-voltage testing.

To achieve the above objective, the present invention discloses a semiconductor structure which comprises a cell region, a junction terminal region, a street line and a passivation layer. The junction terminal region is disposed to surround the cell region and has a plurality of guard rings which are disposed in the junction terminal region and surround the cell region. The street line is disposed to surround the junction terminal region. The passivation layer covers the junction terminal region and the street line, and the passivation layer substantially prevents the street line from being damaged due to arcing generated during a high-voltage test.

In one embodiment of a semiconductor structure of the present invention, the passivation layer is selected from a group consisting of silicon dioxide, silicon nitride, photoresist (PR) and combinations thereof.

In one embodiment of a semiconductor structure of the present invention, the semiconductor structure further comprises a die edge region disposed between the junction terminal region and the street line to surround the junction terminal region. The passivation layer covers the junction terminal region, the die edge region and the street line to prevent the arcing generated in the street line during a high-voltage test.

In one embodiment of a semiconductor structure of the present invention, the semiconductor structure further comprises an interlayer dielectric layer, disposed between the passivation layer and the junction terminal region for covering the junction terminal region and a portion of the die edge region.

In one embodiment of a semiconductor structure of the present invention, the interlayer dielectric layer covers the junction terminal region, the die edge region and the street line.

In one embodiment of a semiconductor structure of the present invention, each of the guard rings is a heavily doped region.

In one embodiment of a semiconductor structure of the present invention, the semiconductor structure further comprises a polysilicon layer, disposed between the interlayer dielectric layer and the junction terminal region for increasing a breakdown voltage of the semiconductor structure.

To achieve the above objective, the present invention discloses a semiconductor structure which comprises a silicon carbide structure, an epitaxial layer, at least one active device, a plurality of guard rings and a passivation layer. The silicon carbide substrate has a cell region, a junction terminal region and a street line from the inside to the outside. The epitaxial layer covers the silicon carbide substrate. The active device is disposed in the epitaxial layer of the cell region. The guard rings are disposed in the epitaxial layer of the junction terminal region for surrounding the cell region. The passivation layer covers the epitaxial layer of the junction terminal region and the street line for substantially preventing the street line from arcing generated during a high-voltage test.

To achieve the above objective, the present invention discloses a method of manufacturing a semiconductor structure, comprising the following steps: providing a silicon carbide substrate, having a cell region, a junction terminal region and a street line from the inside to the outside; providing an epitaxial layer, covering the silicon carbide substrate; providing a plurality of guard rings disposed in the epitaxial layer of the junction terminal region for surrounding the cell region; and providing a passivation layer, covering the epitaxial layer of the junction terminal region and the street line, wherein the passivation layer substantially prevents the street line from arcing generated during a high-voltage test.

In one embodiment of a method for manufacturing a semiconductor structure of the present invention, the step of providing a passivation layer is to form a passivation layer selected from a group consisting of silicon dioxide, silicon nitride, photoresist (PR) and combinations thereof.

In one embodiment of a method for manufacturing a semiconductor structure of the present invention, the manufacturing method further provides a die edge region disposed between the junction terminal region and the street line to surround the junction terminal region so that the passivation layer covers the junction terminal region, the die edge region and the street line to prevent the arcing generated in the street line during a high-voltage test.

In one embodiment of a method for manufacturing a semiconductor structure of the present invention, the manufacturing method further provides an interlayer dielectric layer, disposed between the passivation layer and the junction terminal region for covering the junction terminal region and a portion of the die edge region.

In one embodiment of a method for manufacturing a semiconductor structure of the present invention, the manufacturing method further provides an interlayer dielectric layer, disposed between the passivation layer and the junction terminal region for covering the junction terminal region, the die edge region and the street line.

In one embodiment of a method for manufacturing a semiconductor structure of the present invention, the manufacturing method further provides a polysilicon layer, disposed between the interlayer dielectric layer and the junction terminal region, for increasing a breakdown voltage of the semiconductor structure.

In one embodiment of a method for manufacturing a semiconductor structure of the present invention, the manufacturing method further provides at least one active device, disposed in the epitaxial layer of the cell region.

After referring to the drawings and the embodiments as described in the following, those the ordinary skilled in this art can understand other objectives of the present invention, as well as the technical means and embodiments of the present invention.

### BRIEF DESCRIPTION OF THE DRAWINGS

FIG. 1 is an enlarged schematic view illustrating damages of portions of the edge regions in a conventional power semiconductor wafer caused by arcing;
FIG. 2 to FIG. 5 are cross-sectional schematic views illustrating the manufacturing process of a semiconductor structure according to an embodiment of the present invention;
FIG. 6 is a cross-sectional schematic view of a semiconductor structure according to another embodiment of the present invention; and
FIG. 7 is a schematic view illustrating the process steps for fabricating the semiconductor structure according to an embodiment of the present invention.

### DETAILED DESCRIPTION OF THE PREFERRED EMBODIMENT

In the following description, the present invention will be explained with reference to various embodiments thereof. These embodiments of the present invention are not intended to limit the present invention to any specific environment, application or particular method for implementations described in these embodiments. Therefore, the description of these embodiments is for illustrative purposes only and is not intended to limit the present invention. It shall be appreciated that, in the following embodiments and the attached drawings, a part of elements not directly related to the present invention may be omitted from the illustration, and dimensional proportions among individual elements and the numbers of each element in the accompanying drawings are provided only for ease of understanding but not to limit the present invention.

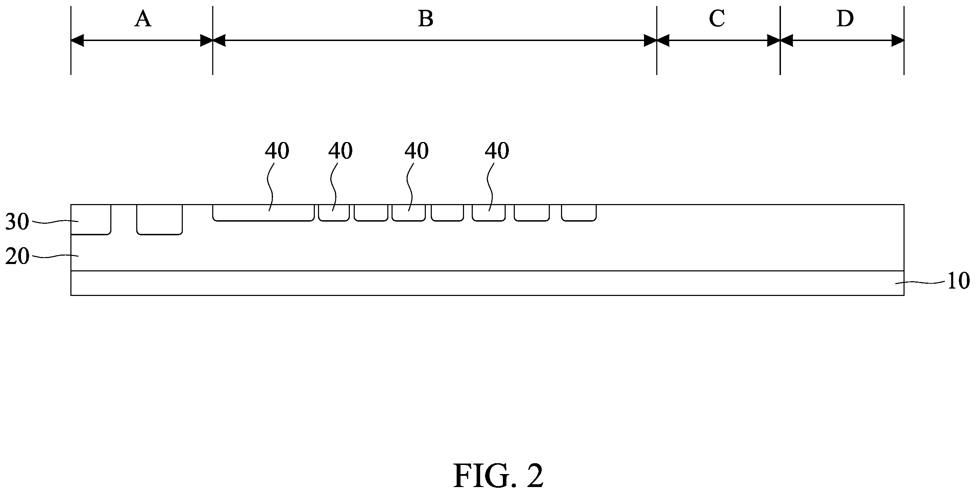

Please refer to FIG. 2 to FIG. 5, which illustrate a method for manufacturing a semiconductor structure according to an embodiment of the present invention, particularly a method for manufacturing a power semiconductor device. The invention is described using a silicon carbide (SiC) power semiconductor device as an example. First, a silicon carbide substrate 10 with a first conductivity type (e.g., N-type) is provided. It is noted that the silicon carbide substrate 10 can be divided into the following regions from the inside outward: a cell region A, a junction termination region B, a die edge region C, and a street line D. The cell region A is the core area of the active devices in the die. The junction termination region B includes edge termination structures to prevent excessive electric field concentration at the edges of the power semiconductor device. The street line D is the area reserved between dies on the wafer for subsequent dicing processes to form individual dies. The die edge region C is located between the junction termination region B and the street line D. During subsequent processing, different components can be formed in these regions, as explained below.

Next, an epitaxial layer 20 is formed on the silicon carbide substrate 10 for covering the surface thereon. In specific embodiments, the epitaxial layer 20 is of the first conductivity type. Additionally, at least one active device 30 is formed in the cell region A within the epitaxial layer 20. It is noted that the illustrated active device 30 is for explanatory purposes only and is not limited thereto. The active device 30 can be a metal-oxide-semiconductor field-effect transistor (MOSFET) or other device types depending on actual requirements, such as an insulated-gate bipolar transistor (IGBT).

Subsequently, a plurality of guard rings 40 are formed in the epitaxial layer 20 of the junction termination region B, surrounding the periphery of the active device 30 in the cell region A. The guard rings are generated through doping techniques such as ion implantation and diffusion for forming highly doped regions of P-type or N-type in the peripheral areas of the silicon carbide substrate 10. In this embodiment, the guard rings 40 are of a second conductivity type (P-type), opposite to the first conductivity type. Since the electric field at the edges of a power semiconductor die is typically high and prone to breakdown, the guard rings 40 provide a gradually diminishing electric field transition zone through different doping concentrations and widths in the doped regions. This mitigates excessive surface electric field concentration on the power semiconductor for reducing breakdown phenomena. This design effectively prevents electric field concentration at junction edges under high voltage for avoiding breakdown voltage degradation and device damage and enhancing reliability and longevity.

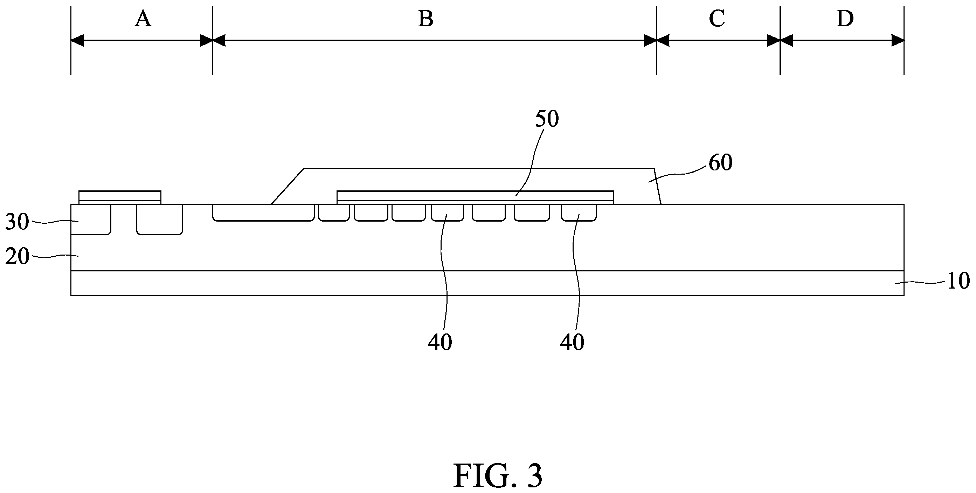

As shown in FIG. 3, thin film processing is performed on the surface of the silicon carbide substrate 10 to form a polycrystalline silicon (poly) layer 50 and an interlayer dielectric (ILD) layer 60. The poly layer 50 and ILD layer 60 are then patterned by etching. The patterned poly layer 50 is disposed on the surface of the epitaxial layer 20 in the junction termination region B and is covered by the patterned ILD layer 60. Specifically, the patterned poly layer 50 is disposed above the guard rings 40 correspondingly and is electrically connected to an appropriate bias voltage to generate a surface field plate electric field for further optimizing the gradient distribution of the surface electric field. This ensures the electric field changes more gradually rather than abruptly increasing at the junction edge for thereby increasing the breakdown voltage of the semiconductor structure. In this embodiment, the patterned ILD layer 60 remains primarily in the junction termination region B and is substantially removed from the die edge region C and the street line D through etching.

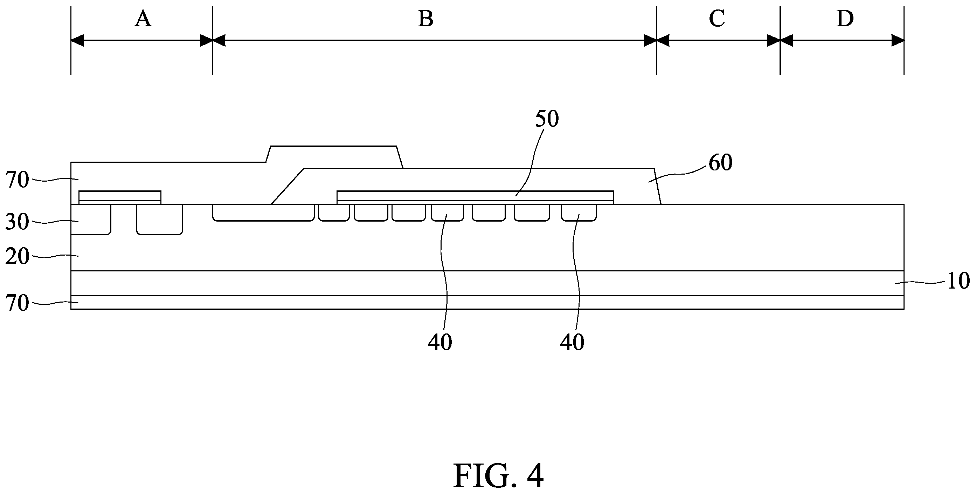

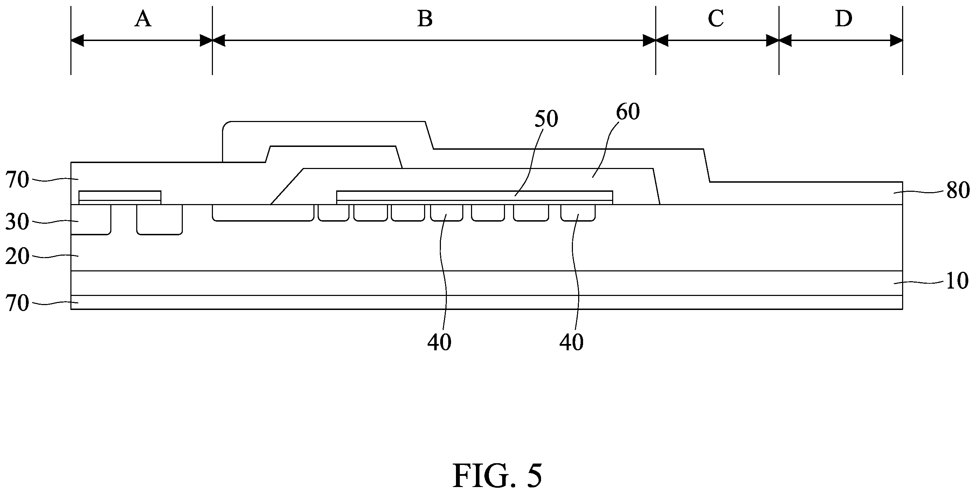

Next, as shown in FIG. 4, a metal interconnection process is performed for forming a patterned metal layer 70 in parts of the cell region A and the junction termination region B. The metal layer 70 includes upper electrodes for the active device 30 and poly layer 50, as well as a bottom electrode on the backside of the silicon carbide substrate 10. Then, as shown in FIG. 5, a dielectric deposition process is performed for forming a protective layer 80 over the junction termination region B, die edge region C, and street line D. This protective layer 80 partially covers the metal layer 70, the ILD layer 60, and exposed parts of the epitaxial layer 20. The materials for the protective layer 80 and the ILD layer 60 can be selected from the group consisting of silicon dioxide, silicon nitride, photoresist (PR), and combinations thereof. Compared with conventional power semiconductor structures, the semiconductor structure of the present invention has a protective dielectric layer 80 in the die edge region C and the street line D for effectively reducing excessive edge electric field concentration and significantly suppressing the possibility of arcing during high-voltage testing.

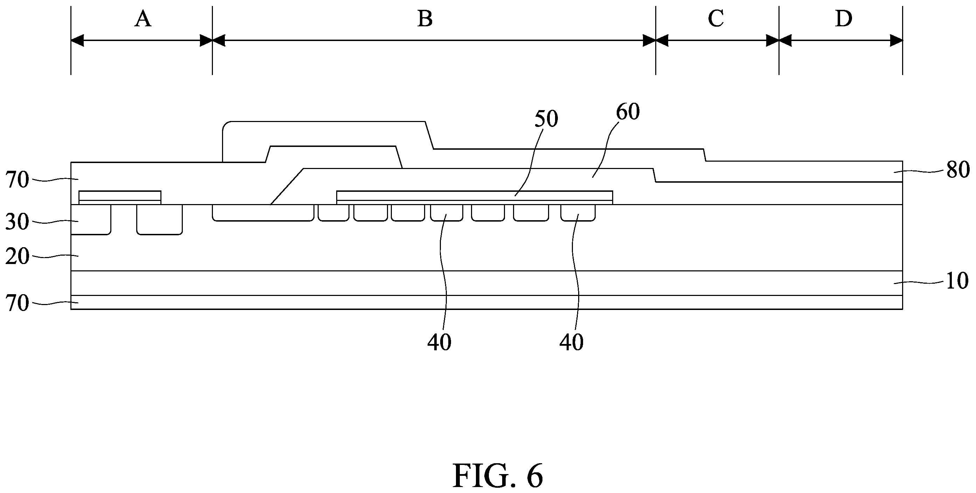

Referring to FIG. 6, another embodiment of the semiconductor structure of the present invention is shown. Unlike the previous embodiment, during the deposition processes of the ILD layer 60 and the protective layer 80, both layers completely cover the junction termination region B, die edge region C, and street line D. This provides higher dielectric strength and better insulation for reducing excessive edge electric field concentration and effectively preventing arcing discharge in the air under high voltage. This allows the structure to withstand higher voltages without breakdown. Thus, whether in the configuration of FIG. 5 or FIG. 6, the semiconductor structure of the present invention effectively suppresses arcing, avoids device damage, and improves reliability.

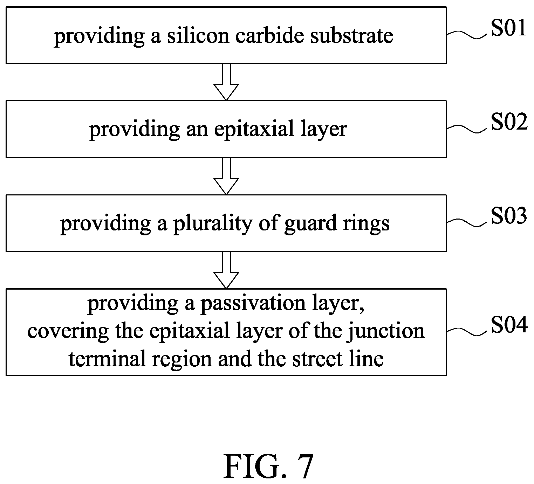

Please refer to FIG. 7, which shows a flowchart of the manufacturing process for the semiconductor structure of the present invention. Step S01: Provide a silicon carbide substrate divided into a cell region, a junction termination region, and a street line. Step S02: Form an epitaxial layer covering the silicon carbide substrate. Step S03: Form a plurality of guard rings in the epitaxial layer of the junction termination region, surrounding the periphery of the cell region. Step S04: Form a protective layer covering the epitaxial layer in the junction termination region and street line, wherein the protective layer effectively prevents damage to the street line caused by arcing during high-voltage testing. Technical details of other components can be found in the previous sections and will not be redundantly described here.

The above embodiments are used only to illustrate the implementations of the present invention and to explain the technical features of the present invention, and are not used to limit the scope of the present invention. Any modifications or equivalent arrangements that can be easily accomplished by people skilled in the art are considered to fall within the scope of the present invention, and the scope of the present invention should be limited by the claims of the patent application.

## Claims

1. A semiconductor structure, comprising:
a cell region;
a junction terminal region, disposed to surround the cell region and having a plurality of guard rings disposed therein for surrounding the cell region;
a street line, disposed to surround the junction terminal region; and
a passivation layer, covering the junction terminal region and the street line,
wherein the passivation layer substantially prevents the street line from being damaged due to arcing generated during a high-voltage test.

2. The semiconductor structure of the previous claim, wherein the passivation layer is selected from a group consisting of silicon dioxide, silicon nitride, photoresist, PR, and combinations thereof and/or wherein each of the guard rings is a heavily doped region.

3. The semiconductor structure of any of the previous claims, further comprising a die edge region disposed between the junction terminal region and the street line to surround the junction terminal region, and the passivation layer covering the junction terminal region, the die edge region and the street line to prevent the arcing generated in the street line during a high-voltage test.

4. The semiconductor structure of the previous claim, further comprising an interlayer dielectric layer, disposed between the passivation layer and the junction terminal region for covering the junction terminal region and a portion of the die edge region.

5. The semiconductor structure of the previous claim, wherein the interlayer dielectric layer covers the junction terminal region, the die edge region and the street line, and/or further comprising a polysilicon layer, disposed between the interlayer dielectric layer and the junction terminal region, for increasing a breakdown voltage of the semiconductor structure.

6. A semiconductor structure, comprising:
a silicon carbide substrate, having a cell region, a junction terminal region and a street line from the inside to the outside;
an epitaxial layer, covering the silicon carbide substrate;
at least one active device, disposed in the epitaxial layer of the cell region;
a plurality of guard rings disposed in the epitaxial layer of the junction terminal region for surrounding the cell region; and
a passivation layer, covering the epitaxial layer of the junction terminal region and the street line,
wherein the passivation layer substantially prevents the street line from arcing generated during a high-voltage test.

7. The semiconductor structure of the previous claim, wherein the passivation layer is selected from a group consisting of silicon dioxide, silicon nitride, photoresist, PR, and combinations thereof and/or wherein each of the guard rings is a heavily doped region.

8. The semiconductor structure of any of the two previous claims, wherein the silicon carbide substrate further comprises a die edge region disposed between the junction terminal region and the street line to surround the junction terminal region, and the passivation layer covers the junction terminal region, the die edge region and the street line to prevent the arcing generated in the street line during a high-voltage test.

9. The semiconductor structure of the previous claim, further comprising an interlayer dielectric layer, disposed between the passivation layer and the junction terminal region for covering the junction terminal region and a portion of the die edge region.

10. The semiconductor structure of claim 11, wherein the interlayer dielectric layer covers the junction terminal region, the die edge region and the street line.

11. A method of manufacturing a semiconductor structure, comprising:
providing a silicon carbide substrate, having a cell region, a junction terminal region and a street line from the inside to the outside;
providing an epitaxial layer, covering the silicon carbide substrate;
providing a plurality of guard rings disposed in the epitaxial layer of the junction terminal region for surrounding the cell region; and
providing a passivation layer, covering the epitaxial layer of the junction terminal region and the street line,
wherein the passivation layer substantially prevents the street line from arcing generated during a high-voltage test.

12. The manufacturing method of the previous claim, wherein the step of providing a passivation layer is to form a passivation layer selected from a group consisting of silicon dioxide, silicon nitride, photoresist, PR, and combinations thereof and/or further providing at least one active device, disposed in the epitaxial layer of the cell region.

13. The manufacturing method of any of the two previous claim, further providing a die edge region disposed between the junction terminal region and the street line to surround the junction terminal region so that the passivation layer covers the junction terminal region, the die edge region and the street line to prevent the arcing generated in the street line during a high-voltage test.

14. The manufacturing method of the previous claim, further providing an interlayer dielectric layer, disposed between the passivation layer and the junction terminal region for covering the junction terminal region and a portion of the die edge region.

15. The manufacturing method of any of the two previous claims, further providing an interlayer dielectric layer, disposed between the passivation layer and the junction terminal region for covering the junction terminal region, the die edge region and the street line, and preferably further providing a polysilicon layer, disposed between the interlayer dielectric layer and the junction terminal region, for increasing a breakdown voltage of the semiconductor structure.
